# EUROPEAN PATENT APPLICATION

(11) **EP 4 113 570 A1**
(43) Date of publication of application: **04.01.2023**
(21) Application number: 21182521.1
(22) Date of filing: 29.06.2021
(51) Int. Cl.: H01J 37/147

(54) **CHARGED PARTICLE ASSESSMENT SYSTEM AND METHOD OF ALIGNING A SAMPLE IN A CHARGED PARTICLE ASSESSMENT SYSTEM**

(71) Applicant: ASML Netherlands B.V., 5500 AH Veldhoven (NL)
(72) Inventor: SLOT, Erwin, 5500 AH Veldhoven (NL)
(74) Representative: ASML Netherlands B.V.

(57) **Abstract**

Disclosed herein is a method of aligning a sample in a charged particle assessment system. The system comprises a support for supporting a sample, and is configured to project charged particles in a multi-beam towards a sample along a multi-beam path, the multi-beam comprising an arrangement of beamlets, and to detect signal particles emitted from the sample in response to a corresponding beamlet of the multi-beam. The method comprises: directing the multi-beam of charged particles along the multi-beam path towards an alignment feature of the sample, such that the field of view of the multi-beam of charged particles encompasses the alignment feature; detecting the signal particles emitted from the sample; generating a dataset representative of the alignment feature based on the detecting of the signal particles; and determining a global alignment of the sample with respect to the multi-beam path, using the dataset.

## Description

### FIELD

The embodiments provided herein generally relate to a charged particle assessment system and a method of aligning a sample in a charged particle assessment system.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Assessment tools such as pattern inspection tools with a charged particle beam have been used to inspect objects, for example to detect pattern defects. Some such tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

In order to perform assessment such as an inspection of a sample, the sample is aligned with respect at least one electron beam path. Sample alignment comprises two steps. In a first step, global alignment or coarse alignment, the sample is aligned with respect to a path of one or more of the electron beams that is the sample placement accuracy is verified. (Note each beamlet of a multi-beam may have a path, and the multi-beam itself may be considered to have a path where the beamlets of the multi-beam have a desired spatial relationship over the sample surface when focused on a sample). Sample positioning of the sample on the sample support is achieved with an accuracy within 500 micrometers or smaller. In global alignment the positioning of the sample on the sample support can be determined more accurately, for example about one-hundred nanometers. In a second step, fine alignment or local alignment, features of the surface of the sample are aligned with respect to the path of one or more of the electron beams. Fine alignment can be achieved with an accuracy of, for example, about one nanometer. After fine alignment is achieved, the relative position of the sample relative to the path of the one or more electron beams is sufficiently accurately known for the assessment, such as an inspection of a sample to start.

In global alignment of the sample to with respect to the electron beam paths is determined. Global alignment of the sample in a SEM can be performed using an optical sensor or optical microscope. With this approach, the optical sensor/microscope is placed close as possible to the SEM. The optical sensor/microscope therefore takes up limited space in the inspection tool. A calibration of the position between SEM and optical sensor/microscope is required which affects sample throughput and alignment accuracy. The accuracy of such a calibration may vary and drift with time. It is desirable to perform the global alignment of the sample to the SEM quickly, accurately and cost effectively.

### SUMMARY

It is an object of the present disclosure to provide embodiments that support improvement of determining the global alignment of a sample to the multi-beam path of a charged-particle assessment systems.

According to a first aspect of the invention, there is provided a method of aligning a sample in a charged particle assessment system comprising a support for supporting a sample, the assessment system being configured to project charged particles in a multi-beam towards a sample along a multi-beam path, the multi-beam comprising an arrangement of beamlets, and being configured to detect signal particles emitted from the sample in response to a corresponding beamlet of the multi-beam, the method comprising: directing the multi-beam of charged particles along the multi-beam path towards an alignment feature of the sample, such that the field of view of the multi-beam of charged particles encompasses the alignment feature; detecting the signal particles emitted from the sample; generating a dataset representative of the alignment feature based on the detecting of the signal particles; and determining a global alignment of the sample with respect to the multi-beam path, using the dataset.

According to a second aspect of the invention there is provided a charged particle assessment system configured to project a multi-beam of charged particles towards a sample comprising an alignment feature, the multi-beam comprising an arrangement of beamlets directed along a multi-beam path, the system comprising: a support for supporting a sample; an optical system for projecting a multi-beam of charged particles towards the sample, the optical system comprising: an array of objective lenses configured to direct a multi-beam of charged particles in an arrangement of beamlets towards the sample, and a detector array associated with the objective lens array and configured to detection signal particles emitted from the sample in response to a corresponding beamlet of the multi-beam; a control system configured to control the optical system to direct the multi-beam of charged particles towards the alignment feature in a field of view encompassing the alignment feature; and a processing system configured to generate an a data set representative of the alignment feature based on the detection of the signal particles and to determine a global alignment of the sample with respect to the at least one electron-optical column from the data set representative of the alignment feature.

Advantages of the present invention will become apparent from the following description taken in conjunction with the accompanying drawings wherein are set forth, by way of illustration and example, certain embodiments of the present invention

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a schematic diagram of an exemplary electron-optical system comprising a macro collimator and macro scan deflector.
**FIG. 5** is a schematic diagram of an exemplary multi-beam apparatus according to an embodiment.
**FIG. 6** is a schematic diagram of part of the multi-beam apparatus of **FIG. 5****.**
**FIG. 7** is a schematic diagram of an exemplary multi-beam apparatus according to an embodiment.
**FIG. 8** is a flow chart illustrating an overview of a global alignment method.
**FIG. 9A** is a schematic diagram of a notch on the rim of a sample and **FIG. 9B** is a schematic diagram of the field of view of the multi-beam encompassing the notch.
**FIG. 10A** is a schematic diagram of an extended primary alignment mark and **FIG. 10B** is a schematic diagram of a pair of scribe lane primary alignment marks.
**FIG. 11** schematically shows a leap and scan approach for scanning sub-beams over a sample.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher through put or much shorter time than a single-beam inspection apparatus. Even if the scanning of individual beams may have a slower speed than for a single beam, net scanning speed of the multi-beam (i.e. considered as s single scanning device) is faster.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

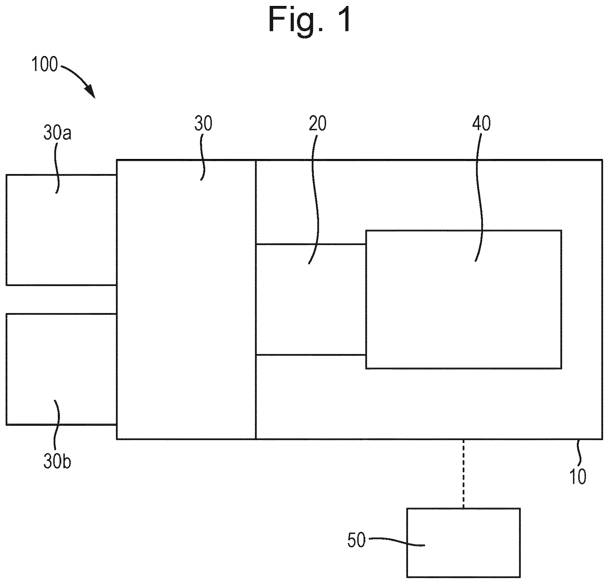

Reference is now made to **FIG. 1****,** which is a schematic diagram illustrating an exemplary charged particle beam inspection apparatus 100. The charged particle beam inspection apparatus 100 of **FIG. 1** includes a main chamber 10, a load lock chamber 20, an electron beam tool 40, an equipment front end module (EFEM) 30 and a controller 50. The electron beam tool 40 is located within the main chamber 10.

The EFEM 30 includes a first loading port 30a and a second loading port 30b. EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

The controller 50 is electronically connected to the electron beam tool 40. The controller 50 may be a processor (such as a computer) configured to control the charged particle beam inspection apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

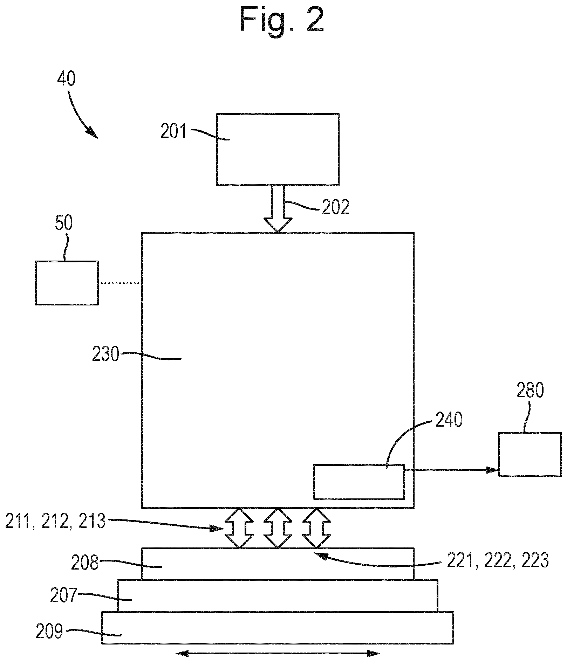

Reference is now made to **FIG. 2****,** which is a schematic diagram illustrating an exemplary electron beam tool 40 including a multi-beam inspection tool that is part of the exemplary charged particle beam inspection apparatus 100 of **FIG. 1****.** The multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. The multi-beam electron beam tool 40 further comprises a detector array 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands or tens of thousands of sub-beams. The sub-beams may be referred to as beamlets.

The controller 50 may be connected to various parts of the charged particle beam inspection apparatus 100 of **FIG. 1****,** such as the electron source 201, the detector array 240, the projection apparatus 230, and the motorized stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV and backscattered electrons typically have electron energy between 50 eV and the landing energy of the primary sub-beams 211, 212, and 213.

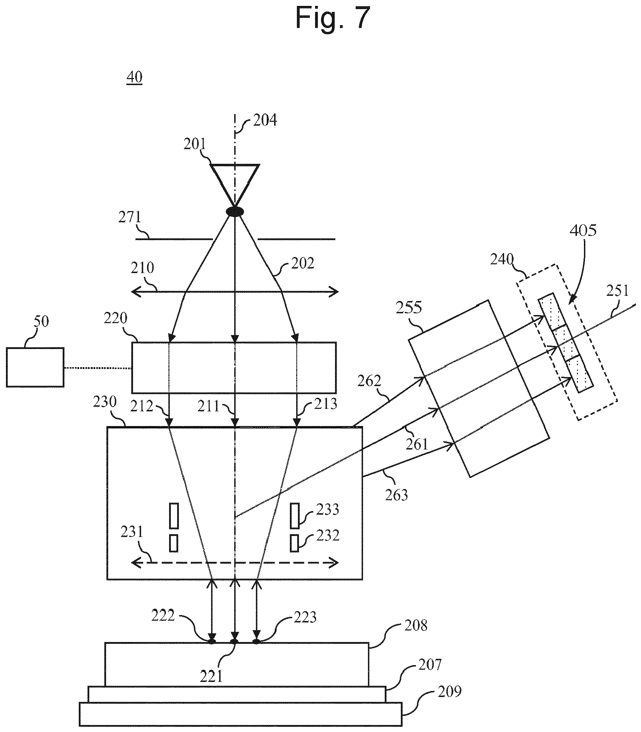

The detector array 240 is configured to detect secondary electrons and/or backscattered electrons and to generate corresponding signals which are sent to a signal processing system 280, e.g. to construct images of the corresponding scanned areas of sample 208. The detector array 240 may be incorporated into the projection apparatus 230. Alternatively, as shown in **FIG. 7** the detector array 240 may be separate from the projection apparatus 230, with a secondary optical column being provided to direct secondary electrons and/or backscattered electrons to the electron detection device.

The signal processing system 280 may comprise a circuit configured to process signals from the detector array 240 so as to form an image. The signal processing system 280 may be separate to projection apparatus 230, as shown in **FIG. 2****,** or may be incorporated in the projection apparatus 230. The signal processing system 280 may be incorporated into a component of the column such as the detector array 240. Alternatively, the signal processing system 280 may be incorporated into the controller 50. The image processing system 280 may include an image acquirer (not shown) and a storage device (not shown). For example, the image processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the detector array 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. Each imaging area may correspond to secondary electrons resulting from a respective sub-beam 211-213. The acquired images may comprise multiple images of a single imaging area of the sample 208 sampled multiple times over a time period. The multiple images may be stored in the storage. The image processing system may be configured to perform image processing steps with the multiple images of the same location of the sample 208.

The image processing system may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

An assessment tool may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron beam apparatus 40 may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

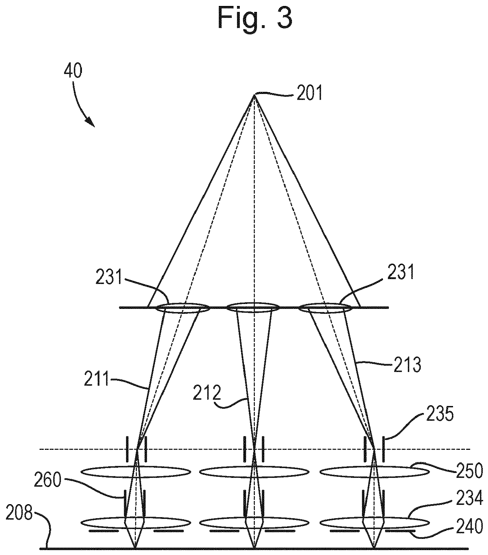

**FIG. 3** is a schematic diagram of an assessment tool including an electron beam tool 40. The electron source 201 directs electrons toward an array of condenser lenses 231 forming part of the projection system 230. The electron source 201 is desirably a high brightness thermal field emitter with a good compromise between brightness and total emission current. There may be many tens, many hundreds or many thousands or tens of thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect. Voltage sources are configured to apply potentials to respective electrodes. A further voltage source may be connected to the sample 208 to apply a potential. Potentials can be defined relative to the sample 208 and/or the source 201.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus. The sub-beams diverge with respect to each other. The sub-beam paths diverge down beam of the condenser lenses 231. In an embodiment deflectors 235 are provided at the intermediate focuses. The deflectors 235 are positioned in the beamlet paths at, or at least around, the position of the corresponding intermediate focusses 233 or focus points (i.e. points of focus). The deflectors are positioned in or close to the beamlet paths at the intermediate image plane of the associated sub-beam. The deflectors 235 are configured to operate on the respective sub-beams 211, 212, 213. The deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the beamlets so that before the deflectors, the beamlets paths with respect to each other are diverging. Down beam of the deflectors the beamlet paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array.

Below (i.e. downbeam or further from source 201) the deflectors 235 there is a control lens array 250 comprising a control lens for each sub-beam 211, 212, 213. The control lens array 250 may comprise three plate electrode arrays connected to respective potential sources. A function of the control lens array 250 is optimize the beam opening angle with respect to the demagnification of the beam and/or to control the beam energy delivered to the objective lenses 234, each of which directs a respective sub-beam 211, 212, 213 onto the sample 208.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub-beam across the sample 208 in one or two directions.

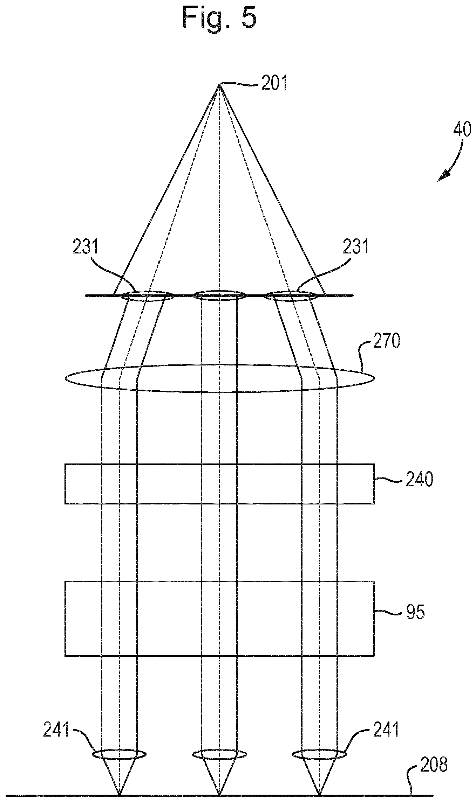

A detector array 240 is provided to detect secondary and/or backscattered electrons emitted from the sample 208. In an embodiment, the detector array 240 is between the objective lenses 234 and the sample 208. However, other positions for the detector array 240 are possible, such as in the objective lens array (see for example EP Application 20184160.8 filed on 6 July 2020 which is hereby incorporated by reference at least so far as the in-lens detector), above the lens as shown in **FIG. 5** and in a secondary column set apart from the primary column as shown in **FIG. 7****,** for example. An exemplary constructions of the detector array 240 are described herein.

The objective lens array 241 can be configured to demagnify the electron beam by a factor greater than 10, desirably in the range of 50 to 100 or more. The objective lens array 241 may comprise a middle electrode, a lower electrode and an upper electrode. Each of the electrodes are provided with an aperture corresponding to each sub-beam, through which the respective sub-beam propagates. The potential for the lower electrode can be similar to the potential of the sample 208. Thus, with three electrodes, the objective lens array may be an array of Einzel lenses. The objective lens array may feature decelerating lenses, which may be suited for detection of secondary signal particles. Another arrangement of objective lens array may have accelerating lenses, which may be suited for detection of backscatter signal particles. One of the electrodes can be omitted. In a two electrode arrangement of an objective lens array, the objective lens array comprises a lower electrode and an upper electrode. An objective lens array 240 having only two electrodes can have lower aberration than an objective lens array 240 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam.. Beneficially the potential differences on such a two electrode lens array enables it to function as a decelerating or accelerating lens array. In an embodiment each element in the objective lens array 241 is a micro-lens operating a different beamlet or group of beamlets in the multi-beam. The objective lens array 241 has at least two plates each with a plurality of holes or apertures. The position of each hole in a plate corresponds to the position of a corresponding hole in the other plate. The corresponding holes operate in use on the same beamlet or group of beamlets in the multi-beam. A suitable example of a type of lens for each element in the array is a two electrode decelerating lens.

In some embodiments, the detector array 240 of the objective lens array assembly is down-beam of at least one electrode of the objective lens array 241. In an embodiment, at least a portion of the detector (e.g. the detector module) is adjacent to and/or integrated with the objective lens array 241. For example, the detector array may be implemented by integrating a CMOS chip detector into a bottom electrode of the objective lens array. Integration of a detector array into the objective lens array 241 or other component of the primary column replaces a secondary column. The CMOS chip is preferably orientated to face the sample (because of the small distance (e.g. 200µm or less, 100µm or less or 50 µm or less) between wafer and bottom of the electron-optical system).

In an embodiment, the detector array 240 comprises a substrate 404 providing a plurality of detector elements that each surround a beam aperture. Each detector element corresponds to a sub-beam of the multi-beam arrangement. Each detector element may comprises sub-portions arranged in a pattern featuring sectors and/or concentric annuli for example around the respective beam aperture. The beam apertures, and so the detector elements are arranged in an array corresponding to the multi-beam arrangement, which may be a rectangular array, in a hexagonal array, or any suitable pattern and variation thereof. The detector elements may comprise a surface facing down-beam. The detector elements may form the bottommost, i.e. most close to the sample 208, surface of the detector array 240. A logic layer is provided between the detector elements and the main body of the substrate At least part of the image processing system may be incorporated into the logic layer 407. The incorporated part of the image processing system may perform at least part of the function of the image processing system The logic layer may comprise at least part of the circuit 60 that embodies at least part of the image processing system. The logic layer may include amplifiers, e.g. Trans Impedance Amplifiers (TIAs), analogue to digital converters, and readout logic. A wiring layer 408 is provided on the backside of, or within, the substrate 404 and connected to the logic layer 407 by through-substrate vias 409. The wiring layer 408 can include control lines, data lines and power lines. A printed circuit board and/or other semiconductor chips may be provided on at least part of, for example the backside of, the detector array 240. Elements of the detector array 240 may be manufactured using a CMOS process with the detector elements 405 forming the final metallization layer. Further details and alternative arrangements of a detector module integrated into an objective lens can be found in EP Application Number 20184160.8, which document is hereby incorporated by reference at least so far as detector arrays and elements integrated into electron-optical components such as an objective lens array.

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

The objective lens array assembly may further comprise a control lens array 250. The control lens array 250 comprises a plurality of control lenses. Each control lens comprises at least two electrodes (e.g. two or three or more electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams, (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In an embodiment, an electron-optical system comprising the objective lens array assembly is configured to control the objective lens assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. In other embodiments, the objective lens array assembly may be configured to form an intermediate focus between the control lens array 250 and the objective lens array 241.

In an embodiment, the control lens array is an exchangeable module, either on its own or in combination with other elements such as the objective lens array and/or detector array. The exchangeable module is configured to be replaceable within the electron-optical tool 40. In an embodiment, the exchangeable module is configured to be field replaceable. Field replaceable is intended to mean that the module may be removed and replaced with the same or different module while maintaining the vacuum in which the electron-optical tool 40 is located. In an embodiment, multiple exchangeable modules are contained within the tool and can be swapped between operable and non-operable positions without opening the tool.

The part of the electron-optical tool 40 for the exchangeable module is isolatable, that is the part of the electron-optical tool 40 is defined by a valve up-beam and a valve down-beam of the exchangeable module. The valves can be operated to isolate the environment between the valves from the vacuum up-beam and down-beam of the valves respectively enabling the exchangeable module to be removed from the electron-optical tool 40 whilst maintaining the vacuum up-beam and down-beam of the part of the column associated with the exchangeable module.

In an embodiment the exchangeable module comprises an electron-optical component which is on a stage permitting actuation for positioning of the component. In an embodiment the exchangeable module comprises a stage. In an arrangement the stage and the exchangeable module may be an integral part of the electron-optical tool 40. In an arrangement the exchangeable module is limited to the stage and the electron-optical device it supports. In an arrangement the stage is removable. In an alternative design the exchangeable module comprising the stage is removable. The stage is configured to support an electron-optical device relative to the beam path. In an embodiment the module comprises one or more actuators. The actuators are associated with the stage. The actuators are configured to move the electron-optical device relative to the beam path. Such actuation may be used to align the electron-optical device and the beam path with respect to each other.

The control lens array 250 may be in the same module as an objective lens array 241, i.e. forming an objective lens array assembly or objective lens arrangement, or it may be in a separate module.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise 2 or 3 or more electrodes. If there are two electrodes then the demagnification and landing energy are controlled together. If there are three or more electrodes the demagnification and landing energy can be controlled independently. The control lenses may thus be configured to adjust the demagnification and/or beam opening angle of respective sub-beams (e.g. using the electric power source to apply suitable respective potentials to the electrodes of the control lenses and the objective lenses). This optimization can be achieved with having an excessively negative impact on the number of objective lenses and without excessively deteriorating aberrations of the objective lenses (e.g. without increasing the strength of the objective lenses).

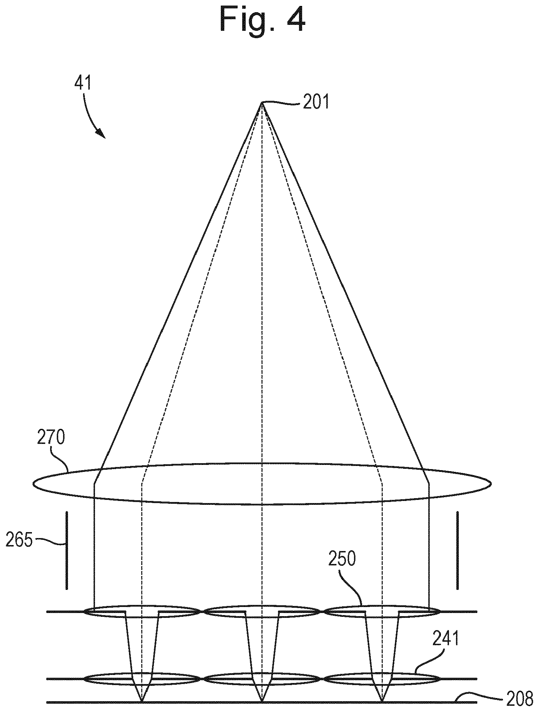

**FIG. 4** is a schematic diagram of an exemplary electron-optical system 41 having the objective lens array assembly. The objective lens array assembly comprises the objective lens array 241. The objective lens array 241 comprises a plurality of objective lenses. For conciseness, features of the electron-optical system 41 and objective lens array 241 that have already been described above, for example as with reference to the electron-optical system 40 as described with respect to and shown in **FIG. 3****,** may not be repeated here.

In the embodiment of **FIG. 4****,** the electron-optical system comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses. In another arrangement (not shown), the macro-collimator may be partially or wholly replaced by a collimator element array that is down-beam of the upper beam limiter. Each collimator element collimates a respective sub-beam. The collimator element array may be the first deflecting or focusing electron-optical array element in the beam path down-beam of the source 201. The collimator element array may be up beam of the control lens array 250.

In the embodiment of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam. The macro scan deflector 265 is provided between the macro collimator 270 and the control lens array 250. In another arrangement an scan deflector array is associated with the objective lens array. The scan deflector array may be up beam of an objective lens array 241. The scan deflector array may be down beam of a control lens array 250. Each scan deflector operates on an associated sub-beam of the multi-beam arrangement.

Any of the objective lens array assemblies described herein may further comprise a detector array 240. The detector array 240 detects charged particles emitted from the sample 208. The detected charged particles may include any of the charged particles detected by an SEM, including secondary and/or backscattered electrons emitted from the sample 208.

**FIG. 5** schematically depicts an electron beam tool 40 according to an embodiment. Features that are the same as those described above are given the same reference numerals. For conciseness, such features are not described in detail with reference to **FIG. 5****.** For example, the source 201, the condenser lenses 231, the macro collimator 270, the objective lens array 241 and the sample 208 may be as described above.

As described above, in an embodiment the detector array 240 is between the objective lens array 241 and the sample 208. The detector array 240 may face the sample 208. In a different embodiment, as shown in **FIG. 5****,** in an embodiment the objective lens array 241, which comprises the plurality of objective lenses, is between the detector array 240 and the sample 208.

In an embodiment a deflector array 95 is between the detector array 240 and the objective lens array 241. In an embodiment the deflector array 95 comprises a Wien filter so that deflector array may be referred to as a beam separator. The deflector array 95 is configured to provide a magnetic field to disentangle the charged particles projected to the sample 208 from the secondary electrons from the sample 208. The Wien filter may be in the form of an array, so that the Wien filter operates separately on one or more lines of beamlets across the multi-beam arrangement. That is, in an embodiment the Wein filter may be a macro-Wien filter with an aperture around the paths of all beamlets of the multi-beam arrangement. In another arrangement, the Wien filter may have two or more apertures, each aperture surrounding one or more lines of paths of beamlets of the multi-beam arrangement.

In an embodiment the detector array 240 is configured to detect charged particles by reference to the energy of the charged particle, i.e. dependent on a band gap. Such a detector may be called an indirect current detector. The secondary electrons emitted from the sample 208 gain energy from the fields between the electrodes. The secondary electrodes have sufficient energy once they reach the detector array 240.

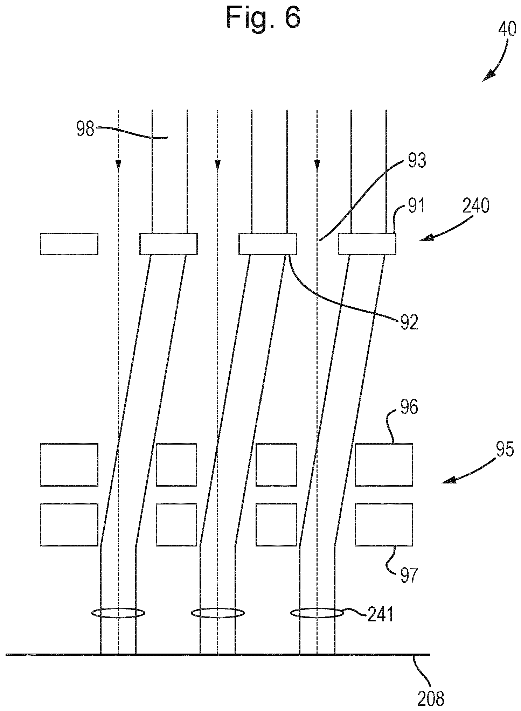

**FIG. 6** is a close-up view of part of the electron beam tool 40 shown in **FIG. 5****.** In an embodiment the detector array 240 comprises an electron to photon converter array 91. The electron to photon converter array 91 comprises a plurality of fluorescent strips 92. Each fluorescent strip 92 is located in the plane of the electron to photon converter array 91. At least one fluorescent strip 92 is arranged between two adjacent charged particle beams projected towards the sample 208.

In an embodiment, the fluorescent strips 92 extend substantially in the horizontal direction. Alternatively, the electron to photon converter array 91 may comprise a plate of a fluorescent material with openings 93 for the projected charged particle beams.

The projected charged particle beams, indicated by dashed lines in **FIG. 6****,** are projected through the plane of the electron to photon converter array 91, via the openings 93 between the fluorescent strips 92, towards the deflector array 95.

In an embodiment the deflector array 95, for example the Wien filter, comprises a magnetic deflector 96 and an electrostatic deflector 97. In each of the magnetic deflector 96 and the electrostatic deflector 97 are a plurality of apertures, each aperture surrounding the paths of at least one line of beamlet paths across the multi-beam arrangement. The electrostatic deflector 97 is configured to counteract the deflection of the magnetic deflector 96 for the projected charged particle beams transmitted towards the sample 208. Accordingly, the projected charged particle beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding secondary electrons created in the sample 208 towards the deflector array 95. For the secondary electrons, which travel in opposite direction with respect to the projected charged particle beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector array 240. The electrostatic and magnetic deflector arrays therefore function as a Wien filter so that a beam path of charged particles is substantially undisturbed in one direction, the primary direction for example towards a sample. A beam path of charged particles is substantially deflected away from the electron-optical axis in the other direction, for example of signal particle, away from the sample. The deflected signal particles may be detected by the detector array, e.g. the fluorescent strips 92.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

**FIG. 7** schematically depicts an electron beam tool 40 according to an embodiment. As described above, in an embodiment the detector array 240 is aligned with the main electron-optical axis of the electron beam tool 40. Alternatively, the detector array 240 may be aligned with a different axis, as shown in **FIG. 7****.**

Features that are the same as those described above are given the same reference numerals. For conciseness, such features are not described in detail with reference to **FIG. 7****.** For example, the source 201, the primary electron beam 202, the sub-beams 211, 212 and 213, the projection apparatus 230, the condenser lenses 231, the probe spots 221, 222, 223, the controller 50, the sample 208, the sample holder 207, the motorized stage 209 and the detector array 240 may be as described above.

The electron source 201, a gun aperture plate 271, a condenser lens 210 and a source conversion unit 220 are components of an illumination apparatus comprised by the electron beam tool 40. The gun aperture plate 271, in operation, is configured to block off peripheral electrons of primary electron beam 202 to reduce the Coulomb effect. The gun aperture plate 271 may be referred to as a Coulomb Aperture Array. The Coulomb effect may enlarge the size of each of probe spots 221, 222, and 223 of primary sub-beams 211, 212, 213, and therefore deteriorate inspection resolution. A gun aperture plate 271 may also include multiple openings for generating primary sub-beams (not shown) even before the source conversion unit 220 and may be referred to as a coulomb aperture array.

The condenser lens 210 is configured to focus (or collimate) primary electron beam 202. In an embodiment of the source conversion unit 220, the source conversion unit 220 may comprise an image-forming element array, an aberration compensator array, a beam-limit aperture array, and a pre-bending micro-deflector array. The pre-bending micro-deflector array may, for example, be optional and may be present in an embodiment in which the condenser lens does not ensure substantially normal incidence of sub-beams originating from the coulomb aperture array onto e.g. the beam-limit aperture array, the image-forming element array, and/or the aberration compensator array.

The electron beam tool 40 may comprise a secondary projection apparatus 255 associated with the detector array 240. The primary projection apparatus 230 may comprise an array of condenser lenses 231 which may be magnetic, which may function as an objective lens. A beam separator 233 and a deflection scanning unit 232 may be positioned inside primary projection apparatus 230. The beam separator 233 may comprise a Wien filter. The detector array 240 may comprise a plurality of detector elements 405.

The components that are used to generate a primary beam may be aligned with a primary electron-optical axis 204 of the electron beam tool 40. These components may include: the electron source 201, the gun aperture plate 271, the condenser lens 210, the source conversion unit 220, the beam separator 233, the deflection scanning unit 232 and the primary projection apparatus 230. The secondary projection apparatus 255 and its associated detector array 240 may be aligned with a secondary electron-optical axis 251 of the electron beam tool 40.

In the current exemplary embodiment, the secondary electrons propagate in three secondary electron beams 261, 262, and 263. The secondary projection apparatus 255 subsequently focuses the path of secondary electron beams 261, 262, and 263 onto a plurality of detector elements 405 of the detector array 240.

The detector elements 405 may detect the secondary electron beams 261, 262, and 263. On incidence of secondary electron beams with the detector elements 405, the elements may generate corresponding intensity signal outputs (not shown). In an embodiment, the detector elements may be capture electrodes. The outputs may be directed to the image processing system.

It may be desirable for charged particle assessment systems, including any of the systems described herein, to be able to selectively turn off one or more (or all) of the sub-beams. This may be desirable for example during exchange of a sample 208, during alignment procedures, or during long movements of the sample 208. It is undesirable to turn off sub-beams by switching off the charged particle source, for example by making an anode potential equal to a cathode potential in the source, or by lowering a temperature of the source. Such action could lead to source instabilities where a source tip shape is a function of both extraction field and temperature, and unnecessary downtime waiting for the source to restabilize the operation of the source after reverting to operational conditions.

An alternative or additional approach is to deflect sub-beams so that the beams are stopped before they reach the sample; (that is the beams are deflected so that they do not pass through an aperture down beam of the source). The structure defining the aperture blocks the sub-beams, for example by deflecting the beams to a beam stop thereby stopping the beams, so acting as a blanker. The deflected sub-beams may cause local surface potential changes (which may be referred to as exposure fingerprints) in the structure providing the blanking functionality, such as the beam stop. The local surface potential changes can be significant enough (e.g. of the order of IV) and close enough to apertures to build up through use and time to cause aberrations and distortions in the sub-beams that are directed to the sample (i.e. are not stopped). Additionally such aberrations may influence such beam paths when the system is turned back on.

Additionally or alternatively, a sub-beam may be blanked by application (e.g. via a controller 50) of a blocking potential to lens electrode of one or more lenses in an array of lenses across the multi-beam arrangement, such as a control lens array. The blocking potential is such as to cause charged particles entering the one or more control lenses towards the sample 208 to be electrostatically reflected away from the sample 208. (Note: to select one or some of the lenses of the lens array at least one of the lens electrodes is a plurality of electrodes on a plate of which one of the electrodes may operate on one or more of the lenses in the array). The blocking potential switches off the sub-beam corresponding to each control lens where the blocking potential is applied. If the blocking potential is applied to all of the control lenses (i.e. to the whole control lens array), all of the multi-beam may be switched off, or blanked. This approach allows sub-beams to be switched off quickly and easily with a lower or negligible risk of exposure fingerprint effects. This is because the sub-beams are not deflected into structure near apertures through which sub-beams will propagate when they are switched back on, which may risk inducing aberrations in the beams. By using such blocking potentials, one or of the beams may be blanked without an additional source of aberrations.

In arrangements where the control lens array 250 comprises three or more control electrodes 501-503 aligned with the sub-beam path of each sub-beam, the system may apply the blocking potential to at least the middle electrode 502 of the three control electrodes 501-503. The control electrode 501 further from the sample 208 may be less suitable because a potential applied to this electrode may be determined by the beam energy delivered by a source module. In arrangements where the control lens array 250 comprises two control electrodes aligned with the sub-beam path of each sub-beam, the system may apply the blocking potential to the control electrode closest to the sample 208. It should be noted that the control electrodes may each be considered to provide an additional degree of freedom to each lens of the objective lens array. Thus instead of referring to the electrodes as a control lens, in an arrangement, the objective lens array can be considered to have one or more additional electrodes which provide additional degrees of freedom besides the multiple electrodes closest to the sample that provide a lensing effect. For example an arrangement comprising an objective lens array may have three extra electrodes up beam of the electrodes providing the objective lens array.

The blocking functionality causes electrons to be reflected away from the sample and some of these electrons may pass back through an array of beam limiting apertures towards the source. However, the proportion of the electrons from the source that are reflected back to the source will be relatively low, due for example to the filtering effect of the beam limiting apertures in both directions, and any effects on the source are expected to be negligible.

A charged particle assessment system may be provided for inspection and/or measurement of a surface of a sample. The sample may have two major surfaces that are opposing (i.e. top front and a back side) and a rim. The charged particle assessment system may comprise the charged particle beam inspection apparatus 100, as described above and shown in **FIG. 1****.** The sample is supported on a support, such as a sample support which may be comprised in a stage. A major surface of the sample may be placed on the support. The sample may be positioned on the support with the aid of one or more pins. The sample may be maintained in position on the sample by way a clamp, such as an electrostatic clamp, operating one of the major surfaces of the sample. The sample may have one or more notches in the rim of the sample. Each notch may engage with a corresponding pin to aid placement of the sample. Before inspecting the area of interest on the sample, the alignment of the sample with respect to the multi-beam path of the charged particle assessment system is determined. Alignment is often done in two phases: global alignment and local alignment.

The purpose of global alignment (or coarse alignment) is to ensure that the sample is aligned with respect to the path of the multi-beam of charged particles. The objective of global alignment may include verifying and determining the accuracy of the placement of the sample relative to the path of the multi-beam of charged particles. In global alignment the alignment position of the sample is determined with respect to the path of multiple-beams of charged particles in at least three degrees of freedom. In an embodiment, the three degrees of freedom are the orthogonal axes in the plane orthogonal to the path of the multi-beam of charged particles (e.g. the positional displacement in the X and Y axes in the plane of the wafer) and the axis of rotation substantially around the path of the multi-beam of charged particles (e.g. Rz the rotational displacement of the wafer about an axis orthogonal to its major plane or a major surface).

In the global alignment phase, alignment features on the rim and/or at least one of the major surfaces of the sample are used to determine global alignment of the sample with respect to the multi-beam path. The positional displacement of the global alignment of the sample is preferably determined within 100 nm with respect to the multi-beam path or at least within a range of 100 nm to 1000 nm. It is preferable to use alignment features disposed at least three different locations of the sample in order to determine the global alignment of the sample with respect to the multi-beam path. In pre-existing arrangements an optical sensor or optical microscope was used for global alignment. Global alignment using a multi-beam arrangement of charged particles with a large field of view avoids using an optical sensor or optical microscope. The same multi-beam path will be used in the inspection process and thus the global alignment of the sample to the multi-beam path is useful for performing inspection of the sample. Furthermore, it may be determined that the global alignment of the sample is determined to be outside an acceptable range, for example the sample is not seated properly in the support and needs to be repositioned before inspection can take place.

The charged particle assessment system comprises a support for supporting the sample. The support may be comprised in an actuated stage 209. The assessment system is configured to project charged particles in a multi-beam towards the sample along a multi-beam path. The multi-beam comprises a plurality of beamlets in an arrangement with respect to each other. The charged particle assessment system is configured to detect signal particles emitted from the sample in response to a corresponding beamlet of the multi-beam. The charged particle assessment system may be used to perform a global alignment method.

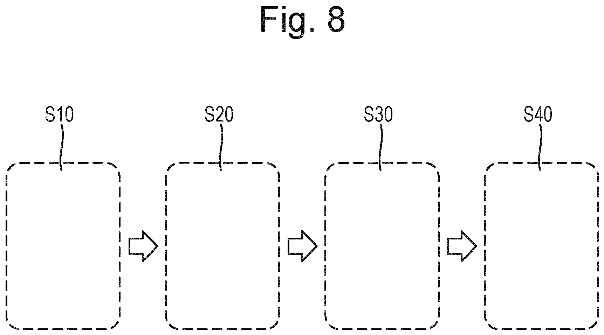

The global alignment method, as illustrated in **FIG. 8****,** comprises a plurality of steps. These steps may comprise a step S10, a step S20, a step S30 and a step S40. The step S10 relates to the usual operation of the charged particle assessment system. The usual operation of the charged particle assessment system includes for example directing the charged particle multi-beam towards a sample. In usual operation of the charged particle system, the multi-beam of charged particles are directed along the multi-beam path towards an alignment feature of the sample. The field of view of the multi-beam of charged particles encompasses the alignment feature. The directing of the multi-beam comprises controlling the support for example to move relative to the path of the charged particle multi-beam so as to move the sample. The support comprises a movable stage 208. The controlling of the support may include moving the support and thus a supported sample. Such movement of the support may move the alignment feature so it is in the multi-beam path. Thus the alignment feature may be moved through the field of view of the multi-beam path for the multi-beams to scan and to be scanned over the sample surface.

In the step S20 of the method the signal particles emitted from the sample are detected. On detection of the signal particles a signal is generated which may be an electrical signal which may be referred to as a detection signal. The step S20 may be considered as a 'detecting step'. The detecting step S20 optionally includes generating a signal from the detected signal particles.

In the step S30 a data set representative of the alignment feature based on the detecting of the signal particles is generated. Generating the data set may comprise processing the signal that is generated from the detected signal particles. The data set may be renderable as an image. The data set may be used to generate an image of the alignment feature. The image of the alignment feature may be used to determine the global alignment of the sample.

In a step S40 a global alignment of the sample is determined. The global alignment of the sample is with respect to the path of the charged particle multi-beam. The global alignment is determined using the data set. The determining step S40 optionally includes determining the topography of the sample in the field of view of the multi-beam. Determining the topography of the sample surface, for example in the field of view, may be based on the intensity of the signal.

Each beamlet of the multi-beam arrangement may be associated with a corresponding signal generated from the detected signal particles. The signal generated in response to each beamlet is for example represented by a pixel. A plurality of pixels may be used to form an image of a portion, for example including an alignment feature, of the sample. The intensity of the signal may correspond to the topography of the sample surface. The intensity of the signal may be higher when the corresponding beamlet is directed at the sample than when the corresponding beamlet is directed to a location away from the sample such as to the support (i.e. the sample support). Global alignment using features of the rim (i.e. rim features), such as a notch, may be determined based on the difference in intensity of certain signals. Such signals may be between signals corresponding to beamlets directed towards the sample and beamlets directed towards the support adjacent to the sample. Consequently, the features of the rim of the sample can be readily identified and used for global alignment. Similarly, the intensity of the signals may be used to generate an image of the alignment feature. For example, the relative contrast such the relative lightness or darkness of a region or a pixel of an image may be indicative of the intensity of the corresponding signal. For example, regions in the field of view of the multi-beam corresponding to lower intensity signals are represented in the image by a darker shade and regions corresponding to higher intensity signals are represented by a lighter shade. Note the indication of signal intensity by reference to relative contrast is a matter of choice so that in a different embodiment a region of lower intensity may be represented lighter contrast than a region of higher intensity.

Conventional pattern matching, image recognition techniques or the like may be used for identification and/or recognition of the feature in the generated image. The global alignment of the sample with respect to the multi-beam path is preferably determined to within 1000nm, more preferably to within 100 nm.

The charged particle assessment system comprises a charged particle optical system for projecting the multi-beam (also referred to herein as the multi-beam of charged particles) towards the sample 208. The sample is supported on a support, which may be a movable stage 209. The charged particle assessment system further comprises a control system and a processing system.

The charged particle optical system may comprise the projection apparatus 230 of **FIG. 2** and/or the corresponding projection apparatus of **FIGS. 3 to 7****.** The charged particle optical system comprises an array of objective lenses. The array of objective lenses is configured to direct a multi-beam of charged particles in an arrangement of beamlets towards the sample. The array of objective lenses may be close to or even proximate the sample. The charged particle optical system may comprise a detector array. Each detector of the detector array may be associated with an beamlet of the multi-beam. The detector array is associated with the objective lens array. Each detector may be associated with a corresponding objective lens of the array of objective lenses. The detector array is configured to detect signal particles emitted from the sample in response to a corresponding beamlet of the multi-beam. The array of objective lenses may correspond to the objective lenses 234 of FIG. 3, the objective lens array 241 of **FIGS. 4 to 6****,** or the condenser lenses 231 of **FIG. 7****.** The detector array may correspond to the detector array 240 of **FIGS. 2 to 7****.**

The control system is configured to control the charged particle optical system to direct the multi-beam of charged particles towards the alignment feature. The multi-beam may have a field of view encompassing the alignment feature. The control system may be configured to control the charged particle optical system to direct the plurality of beamlets of the multi-beam simultaneously towards the alignment feature. The control system may comprise controller 50 of **FIGS. 1****,** **2** **and** **7****.** Thus, the control system may be integrated in the assessment system 100, may be disposed separately or may have elements integrated in the assessment system and other elements disposed separately.

The processing system is configured to generate a data set representative of the alignment feature based on the detection of the signal particles. The processing system is further configured to determine a global alignment of the sample with respect to the path of the charged particle multi-beam from the data set that is representative of the alignment feature. The processing system may be the processing system 280 as described above in regards to **FIG. 2****.** Thus, the processing system may be integrated in the projection apparatus 230 and/or may be disposed separately.

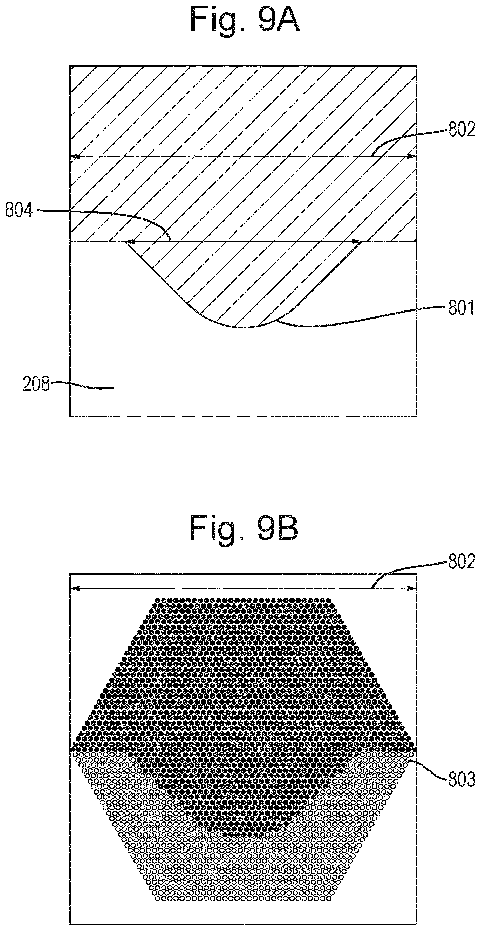

The alignment feature may comprise a portion of the rim of the sample. The alignment feature may be a feature defined in or on the rim of the sample. The feature may comprise the perimeter of both major surfaces of the sample, for example at the position of the feature in or on the rim. The feature may be a geometrical shape or characteristic of the sample, for example at last a portion of the rim. For example, as shown in **FIG. 9A****,** the alignment feature may comprise a notch in the rim of the sample. The notch may be an indentation of the perimeter of either of the major surfaces of the sample. The alignment feature might be a part of the rim of the sample that does not comprise, for example define, a notch. The geometry of a feature of a sample, for example the shape of a rim of sample, may be used to determine the global alignment of the sample. For example, where samples have similar shapes and sizes, sample-to-sample dimensional variations, such of a diameter of a major surface (for example up to 200 micrometers) may lead to both edge/rim position variations with respect to the coordinate system of the sample support. As another example, where samples have similar shapes and sizes, sample-to-sample variations in pattern position. In particular, the position of the pattern on the major surface of a sample relative to the rim of the sample may vary (for example up to 200 micrometers).

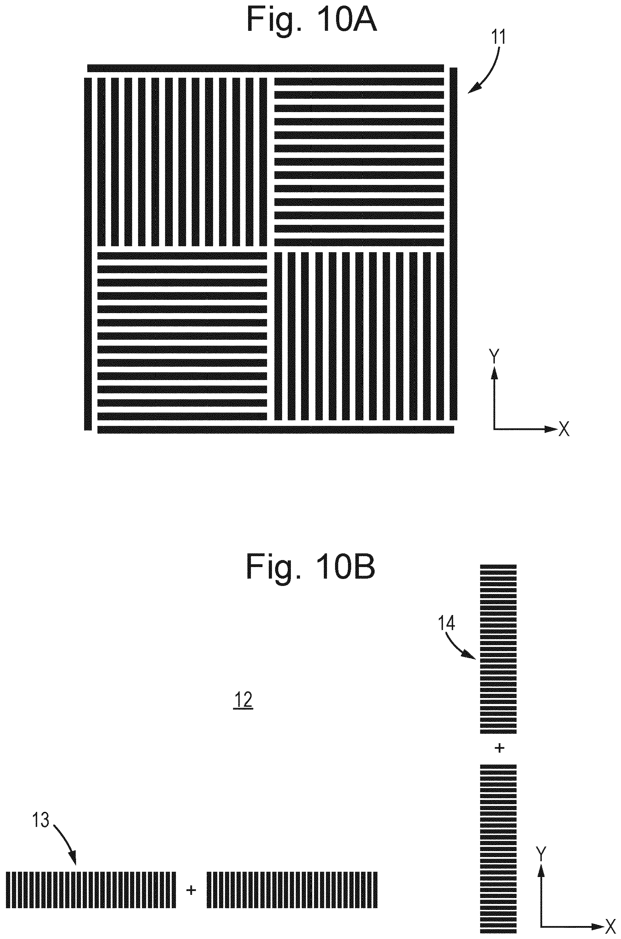

The alignment feature may comprise a feature of a major surface of the sample. For example, the alignment feature may comprise an alignment mark on a major surface of the sample. Each alignment mark may have a length, in a direction along the major surface of the sample, of for example 10 to 50 micrometers. The alignment mark may be an extended primary mark (XPA), for example as shown in **FIG. 10A****.** With this kind of alignment mark, the alignment of the X and Y coordinates may be determined due to the orthogonal arrangement of lines of the XPA mark 11. The XPA mark 11 of **FIG. 10A** includes four groups of lines arranged in a square shape, including two groups of lines arranged in a Y direction and two groups of lines arranged in an X direction, to achieve global alignment in the X and Y directions respectively. Alternatively or additionally a different type of alignment mark on or in the surface of the sample may be used, such as a scribe-lane primary mark (SPM), for example as shown in **FIG. 10B****.** An SPM is a mark in the scribe lane between dies that may be used for alignment processes. The SPM mark 12 comprises a pair of marks 13, 14. The pair of marks includes a group of lines arranged in an X direction 13 and a group of lines arranged in a Y direction 14. The marks may be spaced apart from each other for example in different scribe lines and/or around a die or field on the sample. The pair of marks 13, 14 may be used to achieve global alignment in the X and Y directions respectively. A known pattern or feature on the major surface of the sample may be used instead of an alignment mark, provided that the dimensions and relative position of the pattern/feature on the sample are known. Use of such alignment marks may provide greater accuracy than use of a geometrical feature of the substrate edge or rim such as a notch. Such a mark may be used by limited number of beams of the charged particle multi-beam arrangement, for example a single beam. In view of sample-to-sample dimensional variations (e.g. of up to 200 micron in diameter), there may be positional variation in alignment marks position with respect to the coordinate system of the sample support.

An alignment feature in or on the rim of the sample, or of the geometrical shape of the rim, are typically larger than features of in or on the major surface of the sample, that may be away from the perimeter of the major surface, such as alignment marks. This means that more beamlets and/or a wider field of view of the multi-beam can be used to determine global alignment. The larger size of the alignment feature can thus provide for a more accurate global alignment. Alignment features on the major surface of the sample, such as alignment marks, may be used to determine more precise, if not sufficiently precise global alignment.

The multi-beam has a field of view. The field of view of the multi-beam is the combined field of view of the beamlets 803 of the multi-beam. In usual operation, the field of view of the multi-beam on a portion of the sample is typically dimensioned larger than a dimension of the alignment feature on the sample. For example, as shown in **FIGS. 9A and 9B****,** the alignment feature of notch 801 in the rim of the sample 208, is encompassed within the field of view of the multi-beam. Thus the field of view of the multi-beam has a dimension 802 on the sample which is greater than the width of the notch 804.

Thus the alignment feature to be scanned in its entirety within the field of view of the multi-beam. It is noted that this is described above, in step S10. The multi-beam is directed along the multi-beam path such that the field of view of the multi-beam encompasses the alignment feature. The consequence of this directing step as shown in **FIGS. 9A and 9B** and described elsewhere herein. The field of view of the multi-beam on the sample is preferably at least 1 mm, more preferably at least 2 mm, yet more preferably at least 3 mm

The field of view of the multi-beam is wide enough to encompass at least one alignment feature of the sample when the multi-beam is directed towards the sample. That is, the alignment feature of the sample fits within the field of view of the multi-beam.

The field of view of the multi-beam may encompasses two or more, e.g. three, alignment features of the sample simultaneously when the multi-beam is directed towards the sample. Such an arrangement improves in accuracy with increased displacement between the different alignment features. Thus this arrangement is more beneficial with multi-beam arrangements with larger field of views. With this arrangement, the global alignment of the sample can be determined quickly because the multi-beam does not need to be directed to each alignment feature separately, in turn. However, relying on having at least three alignment features in the field of view of the multi-beam can have an impact on accuracy. For an example, a typical accurate alignment for rotation uses alignment marks approximately in the range of 10 to 50 mm apart, for example 30 mm. For a field of view smaller than the maximum of this range, for example 10 mm, it is preferable to scan the marks separately. Using marks closer together, in the field of view thus may impact accuracy. Such alignment features may include a notch and an alignment feature (e.g. an alignment mark in a scribe lane near the sample perimeter) on the sample surfaces which as such may fit within the field of view.

The data set used to determine the global alignment may comprise data corresponding to signal particles associated with all of the beamlets the charges particle assessment system is configures to project. Alternatively, a data set from a selection of beamlets may be sufficient to determine the global alignment, provided the combined field of view of the selection of beamlets of the multi-beam arrangement may encompasses the alignment feature. As noted a multi-beam arrangement may comprise anything from around ten to tens of thousands or more beamlets. In a multi-beam arrangement of at least one hundred beamlets, the selection of beamlets may comprise at least 50 to 100 beamlets, and preferably comprises at least 60 beamlets. The selection of beamlets may adjoin each other and define a portion of the multi-beam arrangement. Alternatively, the selection of beamlets may be disposed or distributed throughout the multi-beam arrangement, preferably in regular pattern in the multi-beam arrangement.

In preparation of the global alignment, a selection of the beamlets of the mulit-beam are selected. For example, in step S10, directing the multi-beam comprises selecting the selection of beamlets from the beam arrangement of the multi-beam. The control system may be configured to control the charged particle optical system to select the selection of beamlets from the beam arrangement. The selecting of beamlets may comprise blanking the beamlets of the multi-beam arrangement other than the beamlets included in the selection of beamlets. The blanking may comprise operating a deflector to operate on a beam to divert it to a beam stop or to control the control lens so a blocking potential is applied to it so as to reflect and thus blank the beam.

Additionally or alternatively detector elements may be selected to select the beamlets, or rather select the detector elements associated with selected beamlets. All the beamlets in the multi-beam arrangement operate. However, only the selected detector elements operate to detect signal electrons in response to interaction of the beamlets with the sample. Thus step S10, may feature the detecting comprising selecting detector elements of a detector array to detect the signal particles emitted from the sample. That is the detector elements selected are those associated with the selected beamlets. Selection of the selected detector elements may be selectively activating the selected detector elements.

Additionally or alternatively detector signals associated with the selected beamlets may be selected. In an embodiment all the beamlets impact the sample. All the corresponding detector elements detect signal electrons emitted by the sample in response to the beamlets. A selection of detection signals may then be selected from all the generated detector signals. The selection of detection signals may be processed to determine an image which may be used to determine the global alignment of the sample relative to the multi-beam path. Thus, the generating of step S30 may comprise selecting detector signals from the detecting (i.e. the step of detecting) for generating the data set. In an arrangement the control system may be configured to select (for example accept, process or receive) a selection of the detection signals. The control system may be configured to select the selected detection signals between the detectors and a memory in which the data signals are stored as a data set. Alternatively or additionally, the control system may be configured to selectively activate a selection of detector elements. The selected detector signals may correspond to the selected detector elements. The selection of detector elements may correspond to the selection of beamlets. The selected detector signals may correspond to the selected beamlets.

Additionally or alternatively data may be selected from the data set corresponding to the selected beamlets. In an embodiment all the detector elements generate detection signals corresponding to the detection of signal particles generated on impact of the corresponding beamlets of the multi-beam arrangement. In such an embodiment, although beamlets are selected, a data set for all beamlets of the multi-beam arrangement is generated, and is for example received and stored in a memory. Data is selected from the dataset to determine the global alignment. In an arrangement, the determining in step S40 may comprise selecting data from the data set corresponding to detection of selected detector elements of the detector array and/or selected beamlets of the multi-beam. The processing system may be configured to selectively process data from a selection of detector elements. The selection of detector elements may correspond to the selection of beamlets. However data in the dataset received may comprise data corresponding to others if not all of the beamlets of the multi-beam arrangement.

Thus, it is possible to determine the global alignment of the sample from a reduced data set comprising data corresponding to signal particles associated with the selection of beamlets. This can be done by directing only the selection of beamlets towards the sample and/or by detecting from only a selection of detector elements from the detector array and/or by selecting a selection of detection signals generated by the detector elements and/or by generating a data set based on data from signal particles associated with only the selection of beamlets. Consequently, the data processing can be performed efficiently. The selection of the data may be adapted to suit the needs of the data path architecture present in the assessment system.

Global alignment using a multi-beam arrangement of charged particles with a large field of view avoids using an optical sensor or optical microscope. (In pre-existing arrangements an optical sensor or optical microscope was used because the limited number of beams available in known multi-beam arrangements of assessment tools, and the small field of view such a limited number of beams provided. If such a multi-beam arrangement were to be used with such a limited field of view, the global alignment would take much longer than an optical measurement). This means that a multi-beam charged particle device embodying the invention does not feature such an optical detection arrangement such as an optical sensor or optical microscope. The cost of goods of multi-beam charged particle device may be reduce by the absence of the optical detection arrangement. The space taken up by the optical detention arrangement may be used for other features. The risk of the optical detection arrangement occluding, obstructing or otherwise interfering with the optimal performance of the charged particle device is prevented. The need to calibrate the position between the path of the multi-beam and the optical detection arrangement is no longer needed, improving throughput. The source of risk of variations and drift in accuracy is removed. Therefore the invention enables performance of global alignment of the sample to the path of the path of the multi-beam more quickly, accurately and cost effectively.

After achievement of global alignment, for example within 100 nm to a micrometer, the process of fine alignment to achieve fine alignment between the path often multi-beam and the sample. Such fine alignment is within nanometers and such fine alignment is expected in future to be within a nanometer. Fine or local alignment may be achieved using alignment features within a field or die of the sample.

In order to obtain a data set corresponding to a portion of a sample surface in the field of view of the multi-beam, the beamlets and the sample surface are scanned relative to each other. In step S10, the detecting may comprise scanning the multi-beam relative to, for example over, at least the alignment feature. Thus the multi-beam is scanned over a portion of the sample surface comprising the alignment feature. The scanning of the multi-beam over the alignment feature may be within the field of view. The resulting data set therefore includes more information about the topography of the sample surface.

The support may be a moveable stage 209. Scanning the multi-beam over the alignment feature may be performed at least in part by moving the support to move the sample relative to the multi-beam path. The control system may be configured to control the support to move the sample relative to the charged particle optical system such that the beamlets of the multi-beam arrangement scans over the alignment feature.

Scanning the multi-beam over the alignment feature may comprise electrostatically deflecting the multi-beam such that the multi-beam scans over the alignment feature.

Either stage movement thereby displacing the sample relative to the path of the charged particle multi-beam or electrostatic deflection of the path may be used to scan the multi-beam over the alignment feature, or the scanning may be performed by a combination of moving the stage and electrostatic deflection.

The scanning of the multi-beam over the alignment feature is over a distance greater than or equal to the beamlet pitch. The beamlet pitch can be defined as the pitch of spots made by each beamlet in the multi-beam arrangement on the sample surface, for example within the field of view of the multi-beam arrangement on the sample surface. On the sample surface, each beamlet is assigned a pitch area of similar size and shape. Each beamlet may have similar reference position in its pitch area which may be the center of the corresponding pitch area. The reference position may be referred to as a grid position. The arrangement of grid positions may define a geometry of the multi-beam arrangement (for example: rectilinear, hexagonal or rhombic). The beamlet pitch may be considered to be the shortest distance between similar locations within the pitch areas of adjacent beamlets or between similar locations in adjacent pitch areas. The pitch may be different between or the same different axes of the geometry of the multi-beam arrangement. Thus, the beamlet pitch is the shortest distance between the points at which adjacent beamlets intersect with the sample, for example during scanning.

In scanning the multi-beam over the alignment feature, the multi-beam arrangement may be scanned over a distance greater than or equal to a dimension in the plane of the sample surface. In an embodiment, the dimension corresponds to the field of view of the selected beamlets. The scanning may be over a distance greater than or equal to the field of view assigned to a beamlet of the multi-beam. In an arrangement the field of view of assigned to such a beamlet is in the range of 50 to 500 µm, for example 50 to 300 micron, for example 50 to 100 µm, more preferably 60 to 70 µm, on the sample. Thus scanning distance of the beamlets is larger, for example 20 to 550 µm, 20 to 120 µm and more preferably 50 to 90 µm.

In an arrangement, the scanning may be a combination of two different orthogonal scan directions. In a one direction the beamlets may be scanned electrostatically. With scan deflectors close to the sample, for example associated with or integrated into the objective lens array, an electrostatic scan deflection is of the order of one micron, for example up to 5, 3 or 1 micron. In another direction orthogonal to the electrostatic scan direction, the support scans relative to the beamlet path. The relative scanning of the support and the beamlet is over the distance greater or equal to the field of view assigned to the beamlet.

Note in an arrangement the scan deflector may be located further away from the sample. In such an arrangement the scan deflection may be larger. If the scan defector is located sufficiently remote from the sample surface, the electrostatic scan range may be sufficient to exceed the maximum field of view assigned to the corresponding beamlet.

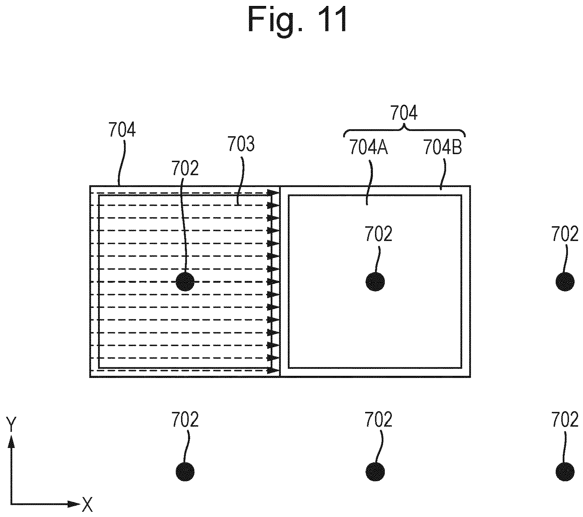

An example scanning method, which may be used to scan the sample, is shown with reference to the schematic depiction of **FIG. 11****.** This method is sometimes referred to as leap and scan. Such a scanning method and arrangement is described in EP Application 21171877.0 filed 3 May 2021, which application is hereby incorporated by reference so far as a scanning method including the method sometimes referred to as leap and scan. Grid positions 702 depict an example geometry of a multi-beam directed onto a sample 208 by the charged particle assessment system. The grid positions 702 show positions of beamlets in the multi-beam. The pitch of the grid positions 702 is equal to the pitch at the sample surface of the beamlets in the multi-beam. Each beamlet is scanned electrostatically in different directions (e.g. X and Y directions) over a pitch area 704 corresponding to the beamlet. Two exemplary pitch areas 704 are labelled. A main scan area is labelled 704A. A border region 704B may additionally be provided to allow for beamlet pitch non-uniformity.

Broken lines 703 are shown in the leftmost example pitch area 704 to schematically represent scan lines along the X-direction. The scan lines may be processed in sequence, one after the other, with a step in the Y direction in between each scan line. The reference to X and Y is merely to demonstrate that the scanning occurs in two different directions that are angled with respect to each other, and may be mutually orthogonal. That is, in an embodiment, the scan lines as depicted are combination two different orthogonal scan directions, for example as described herein in which the electrostatic scan is of the order of 1 micron and a mechanical scan of the sample relative to the beamlet is over the distance greater or equal to the field of view assigned to the beamlet. Sequential scan lines may follow one from the other, i.e. meander, or all scan lines may start from the side of the pitch area. The scanning process continues until each beamlet has processed all of its pitch area 704. The pitch areas 704 are processed by respective beamlets in parallel. That is, the beamlets scan their respective pitch areas 704 simultaneously.

When the beamlets have finished processing the pitch areas 704, the sample is moved to a different position (which may be referred to as a leap because of the relatively large distance involved). The process (e.g. scanning) is then repeated to process pitch areas 704 at this new position of the sample. The leap may move the sample so a different portion of the sample surface corresponds to the footprint of the multi-beam.

The new position may be such as to cause scanning of a region or portion on the sample that is adjacent to the region scanned at the previous position of the sample in order to scan a large continuous area; that is the regions may be contiguous. (Such contiguous regions of the sample surface may be referred to as a scanned area.) Alternatively or additionally, the new position may be such as to cause scanning of a region on the sample that is separated from the region scanned at the previous position of the sample. The two regions may be spaced apart. Processing such spaced apart regions may be used during global alignment when aligning with multiple alignment features of which at least two may be with in portions of the sample surface that are spaced apart.

At each new position, the scanning of each pitch area (e.g. scanning of a beamlet in X and stepping the beamlet in Y) involves deflecting the beamlets electrostatically (e.g. scanning in X and stepping in Y) over a distance that is substantially equal to the pitch of the beamlets in the multi-beam.

It should be noted that the beamlets in the multi-beam arrangement are arranged in a grid of at least two axes. When selecting detection signals and the like for processing, the corresponding selected detector elements and beamlets may form a pattern on the grid. The selected beamlets may be equally spaced apart in one or more axis.

The charged particle assessment system may comprises a single source 201, as shown in **FIGS. 2 to 5****,** or may comprise a plurality of sources for generating charged particles to project towards the sample. Each source may correspond to a single beamlet or may correspond to a plurality of beamlets, such as sub-beams 211-213 as shown in **FIGS. 2****,** **3** **and** **7****.** Each source may correspond to a single charged particle column, such as the electron beam tool 40 of **FIGS. 2 to 5****,** or may correspond to a plurality of charged particle columns.

If the charged particle assessment system comprises a plurality of sources, each source emits a charged particle beam. A multi-beam of beamlets is generated from each respective charged particle beam emitted by a source. The collection of the multi-beams associated with the plurality of sources may be referred to as a multi-multi-beam. Thus a method of operation of the charged particle assessment system may comprise emitting charged particle beams from the plurality of sources and generating from each beam from a respective source, a respective multi-beam of beamlets along the multi-beam path for example towards a sample. The global alignment method may further comprise the method of operation of the charged particle assessment system.

Preferably the charged particle assessment system comprises at least a first and a second charged particle-optical column (or a first and second column). The first and second columns correspond to, e.g. projecting, at least a first part and second part of the multi-beam arrangement as a first component multi-beam and a second component multi-beam. The first and second columns may have respective first and second multi-beam paths for the respective first and second component multi-beams. The first multi-beam path may be calibrated with respect to the second multi-beam path. In this configuration, the charged particle optical system may comprise the first and second parts of the multi-beam system. The first part of the charged particle optical system may correspond to a first charged particle-optical column and the second part of the charged particle optical system may correspond to a second charged particle optical system. The first and second parts of the multi-beam arrangement may be controlled independently, e.g. by the corresponding first and second charged particle optical columns, for example in being directed towards a sample. (The positioning of the first and second parts of the multi-beam arrangement on a sample may be controlled by the controlling the stage). The first and second parts of the multi-beam arrangement are exemplary, and the multi-beam arrangement may comprises as many parts, i.e. charged particle optical systems or columns as desired for example in a rectilinear arrangement of any size or shape, e.g. nine, one-hundred, four hundred, etc. or a hexagonal arrangement of any size or shape e.g. thirty six, three-hundred and sixty one, two thousand one hundred and sixty six, etc.. For example, the multi-beam arrangement may comprises three parts, i.e. three charged particle optical systems or columns. There may be an alignment feature for each part, or a selection of the parts. For example the first and second parts each have a corresponding alignment feature, e.g. a first and a second alignment feature.

Optionally, in the directing of the multi-multi-beam, the first column projects the first part of the multi-beam arrangement towards the first alignment feature as the first component multi-beam and the second column projects the second part of the multi-beam arrangement as the second component multi-beam towards the second alignment feature. The first and second component multi-beams may be projected towards the first alignment feature and the second alignment features simultaneously and respectively.

The control system may be configured to control the first column to direct the first component multi-beam towards the alignment feature in a field of view encompassing the first alignment feature. The control system may be configured to control the second column to direct the second component multi-beam towards the second alignment feature in a field of view encompassing the second alignment feature. The control system may be configured to control the first and second columns to project the respective first and second component multi-beams towards the sample simultaneously. In this way two data sets for the first and second alignment features may be obtained simultaneously. The simultaneous obtaining of these two data sets may be desirable when the first and second alignment features are in portions of a sample surface that are too far apart from each other to be obtained in the field of view of one multi-beam arrangement, for example that is a part of a multiple charged particle column assessment tool. Thus, in this way a plurality of alignment features can be gathered simultaneously. The data sets can be used to determine the global alignment of the sample. Therefore, the ability to simultaneously scan multiple alignment features simultaneously increases the speed of alignment and thus can increase throughput of samples in the process of global alignment of the sample. This can be advantageous in providing timely and therefore cost effective sample inspection.

In the method of global alignment, the steps S10 to S40 of **FIG. 8****,** may be performed on an second alignment feature. The second alignment feature may be feature of a rim or a major surface feature of the sample as described above, such as an alignment mark or geometrical characteristic such as a shape of a of a portion of the surface of a sample. The second alignment feature is disposed at a different location on the sample than the first alignment feature.

The directing of the multi-beam arrangement may comprise directing the second component multi-beam towards the second alignment feature. Alternatively or additionally, the directing of the multi-beam arrangement may comprise directing the first component multi-beam towards the second alignment feature. Such control may comprise controlling the stage to position the sample relative to the first and/or second columns. The control system may be configured to control the control the first column to direct the multi-beam arrangement towards the second alignment feature in a field of view encompassing the second alignment feature. The first component multi-beam is, for example, controlled to move such that the field of view of the first component multi-beam encompasses the second alignment feature.

A data set representative of the second alignment feature based on the detecting of the signal particles may be generated. The processing system may be configured to generate the data set representative of the second alignment feature based on the detection of the signal particles. The processing system may further be configured to determine the global alignment of the sample with respect to the multi-beam path of the respective multi-beam component from the data set representative of the second alignment feature and/or from the data set representative of the first alignment feature. The global alignment of the sample being with respect to the multi-beam path of the respective multi-beam component may therefore be determined based on the data set gathered for the first alignment feature and/or the second feature. Since the first and second columns, and this the first multi-beam path and the second multi-beam path are calibrated with respect to each other, a global alignment may be determined.

References to upper and lower, up and down, above and below, etc. in relation to embodiments containing or using a particle trap should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beamlet paths of the multi-beam. Electrodes may be present above, below or between the pole plates to control and optimize the electromagnetic field of the compound lens array.

Where electrodes or other elements are provided that can be set to different potentials relative to each other it will be understood that such electrodes/elements will be electrically isolated from each other. If the electrodes/elements are mechanically connected to each other, electrically insulating connectors may be provided. For example, where electrodes/elements are provided as a series of conductive plates that each define an aperture array, for example to form an objective lens array or control lens array, electrically insulating plates may be provided between the conductive plates. The insulating plates may be connected to the conductive plates and thereby act as insulating connectors. The conductive plates may be separated from each other along sub-beam paths by the insulating plates.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

Embodiments of the invention are set out in the following numbered clauses:
Clause 1: A method of aligning a sample in a charged particle assessment system comprising a support for supporting a sample, the assessment system being configured to project charged particles in a multi-beam towards a sample along a multi-beam path, the multi-beam comprising an arrangement of beamlets, and being configured to detect signal particles emitted from the sample in response to a corresponding beamlet of the multi-beam, the method comprising: directing the multi-beam of charged particles along the multi-beam path towards an alignment feature of the sample, such that the field of view of the multi-beam of charged particles encompasses the alignment feature; detecting the signal particles emitted from the sample; generating a data set representative of the alignment feature based on the detecting of the signal particles; and determining a global alignment of the sample with respect to the multi-beam path, using the data set.
Clause 2: The method of clause 1, wherein the plurality of beamlets are simultaneously directed towards the alignment feature.
Clause 3: The method of clause 1 or 2, wherein the combined field of view of a selection of beamlets of the multi-beam arrangement encompasses the alignment feature.
Clause 4: The method of any of clause 3, wherein the selection comprises at least 50 to 100 beamlets, preferably at least 60 beamlets.
Clause 5: The method clause 3 or 4, wherein directing the multi-beam comprises selecting the selection of beamlets from the multi-beam arrangement, the selection of beamlets adjoining each other defining a portion of the multi-beam arrangement or the selection of beamlets being disposed throughout the multi-beam arrangement preferably in regular pattern in the multi-beam arrangement.
Clause 6: The method of clause 5 wherein the selecting comprises blanking the beamlets of the multi-beam arrangement not included in the selection of beamlets; or wherein multi-beam arrangement comprising the selection of beamlets and unselected beamlets, wherein the selecting comprises blanking the unselected beamlets.
Clause 7: The method of any one of clauses 1 to 6, wherein the field of view of the multi-beam of charged particles on the sample is at least 3 mm
Clause 8: The method of any of clauses 1 to 7, wherein directing the multi-beam comprises scanning the multi-beam of charged particles over the alignment feature.
Clause 9: The method of clause 8, wherein scanning the multi-beam over the alignment feature comprises moving the support to move the sample relative to the multi-beam path and/or electrostatically deflecting the multi-beam such that the multi-beam of charged particles scans over the alignment feature.
Clause 10: The method of either of clauses 8 and 9, wherein the scanning of the multi-beam of charged particles over the alignment feature is over a distance greater than or equal to the beamlet pitch.
Clause 11: The method of any of clauses 8 to 10, wherein the scanning of the multi-beam of charged particles over the alignment feature is over a distance greater than or equal to a dimension in the plane of the sample surface of portion of beam arrangement and/or the field of view assigned to a beamlet of the multi-beam, the distance is preferably in the range of 50 to 200 micrometers for example 50 to 100 micrometers more preferably 60 or 70 micrometers.
Clause 12: The method of any of clauses 8 to 11, wherein the scanning on the multi-beam of charged particles over the alignment feature is within the field of view.
Clause 13: The method of any of clauses 1 to 12, wherein the directing the multi-beam of charged particles along the multi-beam path towards an alignment feature of the sample comprises controlling movement and/or positioning of the support so that the alignment feature is in the multi-beam path of charged particles.
Clause 14: The method of any one of clauses 1 to 13, wherein the charged particle assessment system comprises a plurality of sources, the method further comprising emitting charged particle beams from the plurality of sources and generating the multi-beam of beamlets along the multi-beam path from the charged particle beams from the plurality of sources.
Clause 15: The method of clause 14, wherein the plurality of sources comprises a charged particle column, preferably the charged particle assessment system comprises at least a first and a second electron-optical column corresponding to at least a first and second part of the multi-beam arrangement.
Clause 16: The method of any of clauses 1 to 15, wherein the multi-beam arrangement comprises at least a first and second part, wherein in the directing of the multi-beam, the first and second part are directed independently.
Clause 17: The method of any of clause 1 to 16 wherein: the directing of the multi-beam comprising directing the multi-beam towards an additional alignment feature in the field of view of the multi-beam, generating a data set representative of the additional alignment feature based on the detecting of the signal particles; and the determining of the global alignment of the sample being with respect to the multi-beam path; wherein the additional alignment feature is at a different location on the sample than the alignment feature.
Clause 18: The method of clause 17 wherein, in the directing of the multi-multi-beam or the multi-beam arrangement, the first part of the multi-beam arrangement projects charged particles towards the alignment feature and the second part of the multi-beam arrangement projects charged particles towards the additional alignment feature.
Clause 19: The method of clause 18, wherein the first and second parts of the multi-beam arrangement project the charged particles towards the alignment feature and the additional alignment features simultaneously.
Clause 20: The method of any of clauses 1 to 19 wherein the detecting comprises selecting detector elements of a detector array to detect.
Clause 21: The method of any of clauses 1 to 20 wherein the generating comprises selecting detector signals from the detecting for generating the data set
Clause 22: The method of any of clauses 1 to 21, wherein the determining comprises selecting data from the data set corresponding to detection of selected detector elements of a detector array.
Clause 23: The method of any of clauses 1 to 22, wherein the determining comprises determining the topography of the sample surface in the field of view of the multi-beam based on the intensity of the signal.
Clause 24: The method of any one of clauses 1 to 23, wherein the alignment feature comprises a feature defined in or on the rim of the sample.
Clause 25: The method of clause 24, wherein the alignment feature comprises a notch in the rim of the sample.
Clause 26: The method of any one of clauses 1 to 24, wherein the alignment feature comprises a feature of a major surface of the sample.
Clause 27: The method of clause 26, wherein the alignment feature comprises an alignment mark.
Clause 28: The method of any of clauses 1 to 27, wherein the alignment feature has a dimension less than the field of view on the sample.
Clause 29: The method of any one of clauses 1 to 28, wherein the global alignment position of the sample with respect to the multi-beam path is determined to within 100 nm.
Clause 30: A charged particle assessment system configured to project a multi-beam of charged particles towards a sample comprising an alignment feature, the multi-beam comprising an arrangement of beamlets directed along a multi-beam path, the system comprising: a support for supporting a sample; an optical system for projecting a multi-beam of charged particles towards the sample, the optical system comprising: an array of objective lenses configured to direct a multi-beam of charged particles in an arrangement of beamlets towards the sample, and a detector array associated with the objective lens array and configured to detect signal particles emitted from the sample in response to a corresponding beamlet of the multi-beam; a control system configured to control the optical system to direct the multi-beam of charged particles towards the alignment feature in a field of view encompassing the alignment feature; and a processing system configured to generate an a data set representative of the alignment feature based on the detection of the signal particles and to determine a global alignment of the sample with respect to the multi-beam path from the data set representative of the alignment feature.
Clause 31: The charged particle assessment system of clause 30, wherein the data set is an image of the alignment feature.
Clause 32: The charged particle assessment system of either of clauses 30 and 31, wherein the optical system comprises one or more optical columns, each column may comprises one or more beamlets of the multi-beam arrangement, optionally all the beamlets of the multi-beam arrangement.
Clause 33: The charged particle assessment system of any of clauses 30 to 32, further comprising one or more sources, each source corresponding to one more beamlets and one or more columns.
Clause 34: The charged particle assessment system of any of clauses 30 to 33, wherein the control system is configured to control the optical system to direct the plurality of beamlets of the multi-beam simultaneously towards the alignment feature.
Clause 35: The charged particle assessment system of any of clauses 30 to 34, wherein the combined field of view of a selection of beamlets of the multi-beam arrangement encompasses the alignment feature.
Clause 36: The charged particle assessment system of clause 35, wherein the selection comprises at least 50 to 100 beamlets, preferably at least 60 beamlets.
Clause 37: The charged particle assessment system of any of clauses 30 to 36, wherein the control system is configured to control the optical system to select a selection of beamlets from the beam arrangement of the multi-beam to direct towards the alignment feature, the selection of beamlets adjoining each other defining a portion of the beam arrangement or the selection of beamlets being disposed throughout the multi-beam arrangement preferably in regular pattern in the multi-beam arrangement.
Clause 38: The charged particle assessment system of clause 37, wherein the optical system is configured to blank the beamlets of the multi-beam arrangement not included in the selection of beamlets.
Clause 39: The charged particle assessment system of any of clauses 30 to 38, wherein the field of view of the multi-beam of charged particles on the sample is at least 3 mm
Clause 40: The charged particle assessment system of any of clauses 30 to 39, wherein the control system is configured to control the optical system and/or movement of the support such that the multi-beam of charged particles scans over the alignment feature.
Clause 41: The charged particle assessment system of clause 40, wherein the control system is configured to control the support to move the sample relative to the optical system and/or to apply an electrostatic deflection to the multi-beam arrangement such that the multi-beam scans over the alignment feature.
Clause 42: The charged particle assessment system of either of clauses 40 and 41, wherein control system is configured to control the optical system and/or the support such that the multi-beam of charged particles scans over the alignment feature for a distance greater than or equal to the beamlet pitch.
Clause 43: The charged particle assessment system of any of clauses 40 to 42, wherein the control system is configured to control the optical system and/or the support such that the multi-beam of charged particles is scanned over the alignment feature for a distance greater than or equal to a dimension in the plane of the sample surface of portion of beam arrangement and/or the field of view assigned to a beamlet of the multi-beam, the distance preferably being in the range of 50 to 200 micrometers for example 50 to 100 micrometers, more preferably 60 or 70 micrometers.
Clause 44: The charged particle assessment system of any of clauses 40 to 43, wherein the control system is configured to control the optical system and/or the support such that the multi-beam of charged particles is scanned over the alignment feature which is within the field of view.
Clause 45: The charged particle assessment system of any of clauses 30 to 44, wherein the control system is configured to control the optical system to direct the multi-beam of charged particles towards an additional alignment feature in a field of view encompassing the additional alignment feature, wherein the additional alignment feature is at a different location on the sample than the alignment feature; and the processing system is configured to generate a data set representative of the alignment feature based on the detection of the signal particles and to determine a global alignment of the sample with respect to the multi-beam path from the data set representative of the additional alignment feature.
Clause 46: The charged particle assessment system of any of clauses 30 to 45, wherein the optical system comprises a first part corresponding to a first part of the multi-beam arrangement and a second part corresponding to a second part of the multi-beam arrangement, wherein the control system is configured to control the first part to direct the multi-beam of charged particles towards the alignment feature in a field of view encompassing the alignment feature and to control the second part to direct the multi-beam of charged particles towards the additional alignment feature in a field of view encompassing the additional alignment feature.
Clause 47: The charged particle assessment system of clause 46, wherein the control system is configured to control the first and second parts of the multi-beam arrangement to project the multi-beam of charged particles towards the alignment feature and the additional alignment feature simultaneously.
Clause 48: The charged particle assessment system of either of clauses 46 and 47 wherein the first part of the optical system corresponds to a first electron-optical column and the second part of the system corresponds to a second optical system.
Clause 49: The charged particle assessment system of any one of clauses 30 to 48, wherein the processing system is configured to determine the global alignment position of the sample with respect to the charged particle beam path to within 100 nm.
Clause 50: A charged particle assessment system configured to project a multi-beam of charged particles towards a sample comprising an alignment feature, the multi-beam comprising an arrangement of beamlets directed along a multi-beam path, the system comprising: a support for supporting a sample; an optical system for projecting a multi-beam of charged particles towards the sample, the optical system comprising: an array of objective lenses configured to direct a multi-beam of charged particles in an arrangement of beamlets towards the sample, and a detector array associated with the objective lens array and configured to detection signal particles emitted from the sample in response to a corresponding beamlet of the multi-beam; and wherein the charged particle assessment system is configured to control the optical system to direct the multi-beam of charged particles towards the alignment feature in a field of view encompassing the alignment feature; to generate an a data set representative of the alignment feature based on the detection of the signal particles and to determine from the data set a global alignment of the sample with respect to the at least one electron-optical column based on the image of the alignment feature.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A method of aligning a sample in a charged particle assessment system comprising a support for supporting a sample, the assessment system being configured to project charged particles in a multi-beam towards a sample along a multi-beam path, the multi-beam comprising an arrangement of beamlets, and being configured to detect signal particles emitted from the sample in response to a corresponding beamlet of the multi-beam, the method comprising:
directing the multi-beam of charged particles along the multi-beam path towards an alignment feature of the sample, such that the field of view of the multi-beam of charged particles encompasses the alignment feature;
detecting the signal particles emitted from the sample;
generating a data set representative of the alignment feature based on the detecting of the signal particles; and
determining a global alignment of the sample with respect to the multi-beam path, using the data set.

2. The method of claim 1, wherein the plurality of beamlets are simultaneously directed towards the alignment feature.

3. The method of claim 1 or 2, wherein the combined field of view of a selection of beamlets of the multi-beam arrangement encompasses the alignment feature and preferably wherein the selection comprises at least 50 to 100 beamlets,.

4. The method claim 3, wherein directing the multi-beam comprises selecting the selection of beamlets from the multi-beam arrangement, the selection of beamlets adjoining each other defining a portion of the multi-beam arrangement or the selection of beamlets being disposed throughout the multi-beam arrangement preferably in a regular pattern in the multi-beam arrangement.

5. The method of claim 4, wherein multi-beam arrangement comprising the selection of beamlets and unselected beamlets, wherein the selecting comprises blanking the unselected beamlets.

6. The method of any of claims 1 to 5, wherein directing the multi-beam comprises scanning the multi-beam of charged particles over the alignment feature.

7. The method of claim 6, wherein the scanning of the multi-beam of charged particles over the alignment feature is over a distance greater than or equal to the beamlet pitch.

8. The method of either of claim 6 or 7, wherein the scanning of the multi-beam of charged particles over the alignment feature is over a distance greater than or equal to a dimension in the plane of the sample surface of portion of beam arrangement and/or the field of view assigned to a beamlet of the multi-beam.

9. The method of any of claims 6 to 8, wherein the scanning on the multi-beam of charged particles over the alignment feature is within the field of view.

10. The method of any of claims 1 to 9, wherein the detecting comprises selecting detector elements of a detector array to detect.

11. The method of any of claims 1 to 10, wherein the generating comprises selecting detector signals from the detecting for generating the data set

12. The method of any of claims 1 to 11, wherein the determining comprises selecting data from the data set corresponding to detection of selected detector elements of a detector array.

13. The method of any of claims 1 to 12, wherein the determining comprises determining the topography of the sample surface in the field of view of the multi-beam based on the intensity of the signal.

14. The method of any one of claims 1 to 13, wherein the alignment feature comprises a feature defined in or on the rim of the sample and/or a feature of a major surface of the sample.

15. The method of any of claims 1 to 14, wherein the alignment feature has a dimension less than the field of view on the sample, and preferably wherein the field of view of the multi-beam of charged particles on the sample is at least 3 mm.
